Europäisches Patentamt

European Patent Office

Office européen des brevets

(11) Publication number: **0 151 811**
**B1**

# EUROPEAN PATENT SPECIFICATION

(45) Date of publication of patent specification: **05.09.90**

(21) Application number: **84116489.0**

(22) Date of filing: **28.12.84**

(51) Int. Cl.⁵: **H 01 J 37/317,**
H 01 J 37/304, H 01 L 21/265

(54) Method for maskless ion implantation.

(30) Priority: **29.12.83 JP 251453/83**

(43) Date of publication of application:
**21.08.85 Bulletin 85/34**

(45) Publication of the grant of the patent:
**05.09.90 Bulletin 90/36**

(84) Designated Contracting States:
**DE FR GB**

(56) References cited:
**EP-A-0 082 639      US-A-4 017 403**

JAPANESE JOURNAL OF APPLIED PHYSICS,
vol. 22, no. 11, November 1983, pages L698-
L701; M. TAMURA et al.: "Electrical properties
of focused-ion-beam boron-implanted silicon"

JOURNAL OF VACUUM SCIENCE AND
TECHNOLOGY, vol. 13, no. 5, September-
October 1976, pages 1030-1036, American
Institute of Physics, New York, US; G. RYDING
et al.: "Features of a high-current implanter and
a medium-current implanter"

(73) Proprietor: **FUJITSU LIMITED**
**1015, Kamikodanaka Nakahara-ku**
**Kawasaki-shi Kanagawa 211 (JP)**

(72) Inventor: **Okamura, Shigeru**
**9-26-208, Satsukicho**
**Ebina-shi Kanagawa, 243-04 (JP)**
Inventor: **Taguchi, Takao**
**17-15, Isehara 1-chome**
**Isehara-shi Kanagawa, 259-11 (JP)**

(74) Representative: **Schmidt-Evers, Jürgen, Dipl.-**
**Ing. et al**
**Patentanwälte Dipl.-Ing. H. Mitscherlich Dipl.-**
**Ing. K. Gunschmann Dipl.-Ing. Dr.rer.nat. W.**
**Körber Dipl.-Ing. J. Schmidt-Evers Dipl.-Ing. W.**
**Melzer Steinsdorfstrasse 10**
**D-8000 München 22 (DE)**

(56) References cited:
**PATENTS ABSTRACTS OF JAPAN, vol. 7, no.**
**194 (E-195)1339r, 24th August 1983; & JP-A-58**
**94 746 (NIPPON DENKI K.K.) 06-06-1983**

**PATENTS ABSTRACTS OF JAPAN, vol. 6, no. 95**
**(E-110)973r, 3rd June 1982; & JP-A-57 27 026**
**(HITACHI SEISAKUSHO K.K.) 13-02-1982**

Courier Press, Leamington Spa, England.

## EP 0 151 811 B1

(56) References cited:
   PATENTS ABSTRACTS OF JAPAN, vol. 6, no.
   230 (E-142)1108r, 16th November 1982; &
   JP-A-57 132 660 (FUJITSU K.K.) 17-08-1982

   PATENTS ABSTRACTS OF JAPAN, vol. 6, no. 6
   (E-89)884r, 14th January 1982; & JP-A-56 126
   918 (HITACHI SEISAKUSHO K.K.) 05-10-1981, &
   US-A-4 494 005

   PHILIPS TECHNICAL REVIEW, vol. 39, no. 1,
   1980, pages 1-14, Eindhoven, NL; W.K. HOFKER
   et al.: "Ion implantation in semiconductors"

   JAPANESE JOURNAL OF APPLIED PHYSICS,
   vol. 21, suppl. 21-1, 1982, pages 3-10,
   Proceedings of the 13th conference on solid-
   state devices, Tokyo, JP; R.L. SELIGER et al.:
   "(Invited) fine focused ion beams"

## Description

The present invention relates to ion implantation of selected impurities or dopants into a substrate of semiconductive material without utilizing a mask, and more particularly to form an ion implanted pattern by selectively scanning a focused ion beam on the surface of a processing substrate.

In the production of elemental devices such as transistor, in a large scale integration (LSI) circuit, it is generally necessary to introduce dopants or impurities into the crystal structure of a semiconductor material. These dopants must be introduced in a specific configuration and within very close tolerances. Introducing the impurities in the required patterns and achieving the desired resolution has proven to be a difficult problem. Impurities have been diffused through a mask which has been formed into a desired configuration by photolithographic processes on the substrate. This method, however, allows the dopants to migrate laterally under the mask, thus adversely affecting resolution. The diffusion method also requires multi-step photolithographic processes which are time consuming and expensive. One way to minimize the adverse resolution by the diffusion is to introduce impurity by means of ion implantation. With ion implantation, the dopant material is ionized and then accelerated into a target substrate through a mask which defines the desired pattern.

Ion implantation methods of the prior art have generally required the use of masks, and it is customary to use an ion beam to implant dopants through a mask placed either directly upon or spaced some distance from the target substrate. Ion implantation with the mask located directly on the substrate, though reducing the lateral migration associated with the diffusion, still is subject to the costs of the photolithographic process.

On the other hand, ion implantation through an apertured mask, spaced from the substrate, eliminates the necessity of masking and etching step; new problems, however, occur in this approach. Because of the necessity of providing supports for the mask, certain configurations may not be obtained by use of masks spaced from the target substrate. For example, using a mask which is spaced from the substrate, it is impossible to implant dopants in an annular or other closed-loop pattern in a single step since the supports for the mask will cast a shade of itself on the substrate. The prior art has recognized the need for a method of ion implantation which avoids these difficulties and thus, maskless ion implantation systems have been proposed.

From G. Ryding et al., "features of a high current implanter and a medium-current implanter", Journal of vacuum science and technology, vol. 13, no. 5, pages 1030 ff. It is for example known that a substrate may be uniformly implanted by applying a couple of wafers in a mechanically scanning apparatus, where they are exhibited to an ion beam. The ion beam power is distributed over several wafers simultaneously and the wafers are moved in a fully mechanical X- and Y-motion to scan the whole batch of wafers through a stationary beam. To achieve uniform doping and to avoid a systematic error due to variations in beam intensity (across the beam profile) the wafers are allowed several coarse scans through the beam rather than a single fine scan.

From Masao Tamura, "Electrical Properties of Focus-Ion-Beam Boron-Implanted Silicon", Japanese Journal of applied physics, vol. 22, no. 11, pages 698 ff. A method for maskless ion implantation with an ion beam having a beam diameter between 0.1 micron and 1 micron and constant current density of about 50 mA/cm$^2$ is known. In this paper the effects of annealing after implanting are discussed. One main parameter in this application is the scan speed of the beam on the substrate.

From W. K. Hofkehr et al., "Ion implantation in semiconductors", Philips Technical Review, vol. 39, no. 1, pages 1 ff. Another ion implantation method and apparatus is known. Again there is a target chamber containing a number of substrates which are mounted on a rotating disk and which are exposed to an ion beam. This is similar to the first above mentioned reference, however, in this paper several principles to calculate the penetration depth are discussed, with the object to ensure uniform and reproducible dosages and therefore uniform doping profiles.

Another processing method using a focused ion beam is known from EP 0 082 639, in which a focused ion beam is used to etch a desired pattern into a substrate. The desired etching depth is preset as a function of location. The etching time, the acceleration voltage and the ion dose may be varied according to different patterns to be etched into the substrate. In this application the table carrying the substrate is mechanically movable.

Finally, a method and an apparatus for implanting ions into a substrate is known from R. L. Seliger et al., "Fine focused ion beams", Japanese Journal of applied physics, vol. 21, pages 3 ff. In this paper direct implantation of dopants into a semiconductor substrate appreciably simplifies the processing of semiconductor devices. There the desired device geometry on the substrate is modified by software. Above described mask changes are avoided, the lateral impurity distribution (doping profile) is varied by varying the dwell time of the ion beam, while the beam is scanned across the substrate. A beam spot diameter 0.2 microns is achieved and an ion beam current of 0.1 nA is used. The beam is programmed such as to raster scan the substrate using a beam dwell time of either 18 or 36 microsec per point. The applied dosage can therefore be varied by integer multiples of two.

Starting from a method for doping into a pattern on a substrate by irradiating said substrate with a focused ion beam of constant current, said irradiation being done by scanning in a step by step movement with a clock frequency, one object of the present invention is to provide an improved method for maskless ion implantation.

This is achieved in that the substrate is scanned N times by said focused ion beam, N being an integer greater than one, the values of N and the clock frequency being chosen such that a predetermined ion density is obtained.

One basic idea of the invention is to provide an ion implantation method providing a desired dose which can be controlled freely and continuously and which can be easily changed for providing different implantation dosages.

Further, the invention provides a freely and continuously variable dosage without readjustment of the focusing system to ensure a sharp ion beam spot.

According to one known and above described method the dosage may only be varied in a coarse manner. Therefore incremental changes of the dosage or even continuously variable dosage cannot be made available according to above-mentioned.

Besides controllability uniformity of the dosage is the other most important factor in ion implantation. This uniformity has to be maintained in sharp and precise pattern structures finally constructing a certain desired device or functional group on the substrate. According to the invention this uniformity can be maintained by overlapping each beam spot with adjacent beam spots in X- and Y-directions. Since the ion current density across the beam cannot be held or made constant, this overlapping is an advantageous feature to sum up said ion current densities of said pitchwise shifted ion beam to finally yield constant overall distribution on scanned surface.

Further, the inventive idea of multiple scanning decreases the risk of causing thermal defects of the substrated which can be effected by either selecting too low clock frequency or too high beam current.

Since varying the beam current misadjusts the focus, the beam current and the focus will be adjusted once, the remaining parameters clock frequency, scanning number and pitch will then be, according to the invention, available to continuously vary the dosage and to maintain uniform doping on the substrate. Since clock frequency is not controllable continuously in methods according to the above described state of the art the dosage, according to such methods, may be controlled continuously only by adjusting the beam current, and thus misadjusting the focus. On the contrary the inventive concept allows for varying the dosage continuously without the need of readjusting the focus.

Another main inventive improvement, the relationship for calculating the desired dosage from mentioned three parameters pitch, clock frequency and scanning number in connection with a given ion current, is subject of claim 4.

Exemplary steps according to the inventive method could, for example, be the following:

A focused ion beam is measured to provide a beam current. The data of the beam current is applied to a control unit. The control unit receives a pattern data to be scanned and an implantation dosage data. By using the pattern data and dosage data, the control unit determines the outputs a data for clock frequency and a scanning number in order to provide a desired dosage. The clock frequency is the one of clock for moving or shifting the focused ion beam step by step during the beam scanning. For this purpose, variable frequency oscillator (V.F.O.) is used for transforming the data for clock frequency into a clock frequency. Thus the scanning conditions are precisely controlled in order to attain the desired implantation dosage. Other objects and advantages of the present invention will become apparent from the following detailed description taken in connection with the accompanying drawings.

Fig. 1A is a schematic plan view of an exemplary pattern of a GaAs field effect transistor.

Fig. 1B illustrates a scanning of pattern on a surface of a substrate by focused ion beam without using a mask.

Fig. 2 is a schematic block diagram illustrating a control system of an ion implantation apparatus.

Fig. 3 is a schematic block diagram illustrating another ion implantation apparatus according to the present invention.

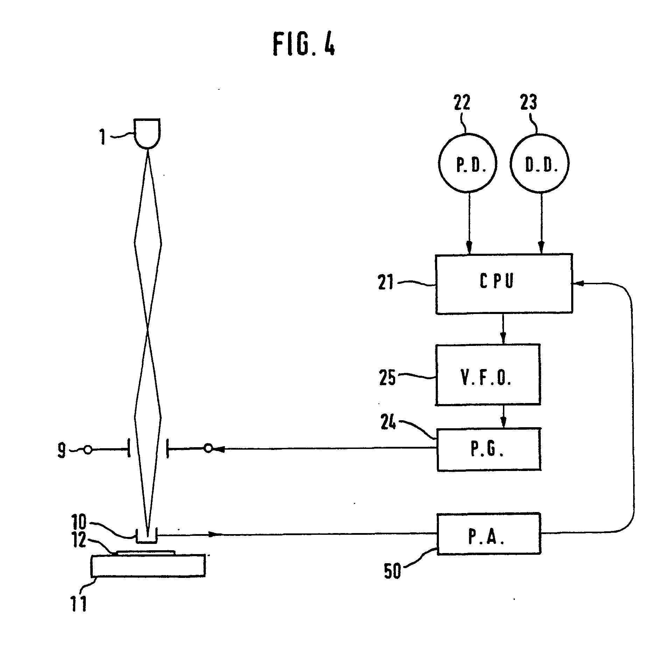

Fig. 4 is a schematic block diagram illustrating an improved control system of ion implantation apparatus by the present invention.

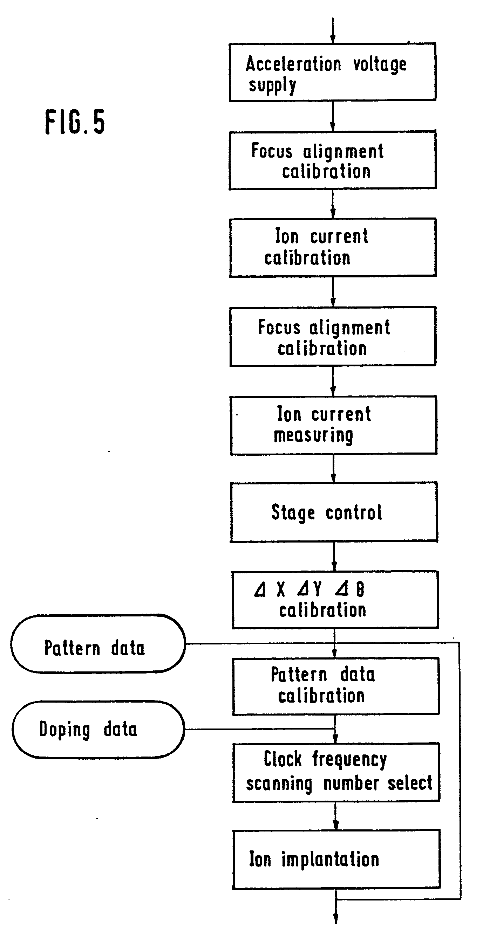

Fig. 5 is a flow chart for controlling an ion implantation apparatus by the present invention.

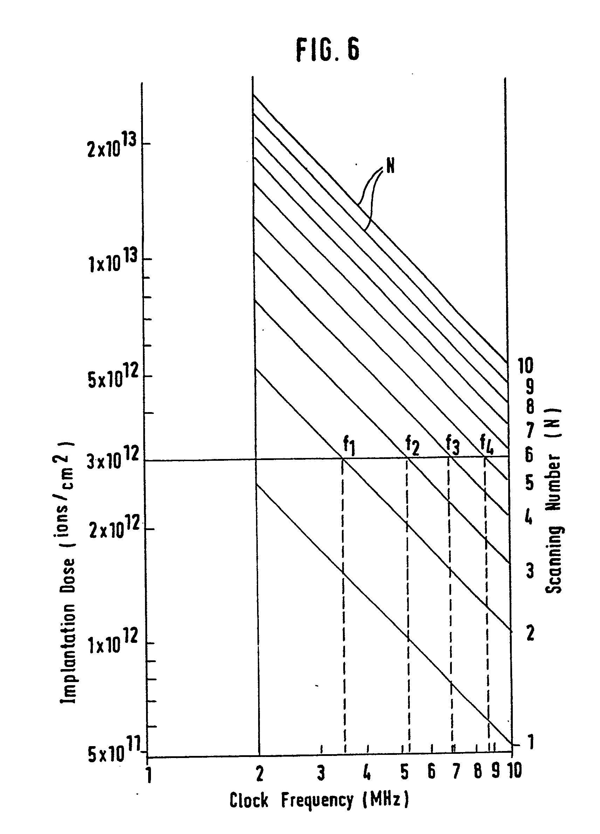

Fig. 6 is a diagram of illustrating a relation between clock frequency and scanning numbers for predetermined dose.

Same or similar reference numerals denote the same or similar parts in all figures.

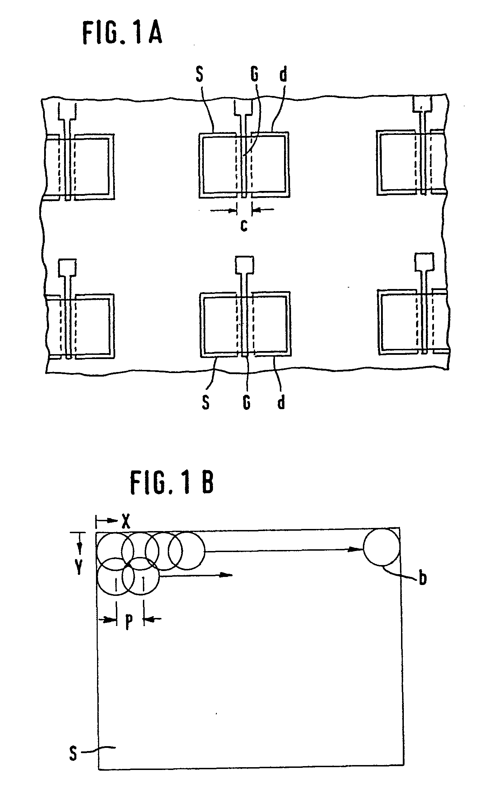

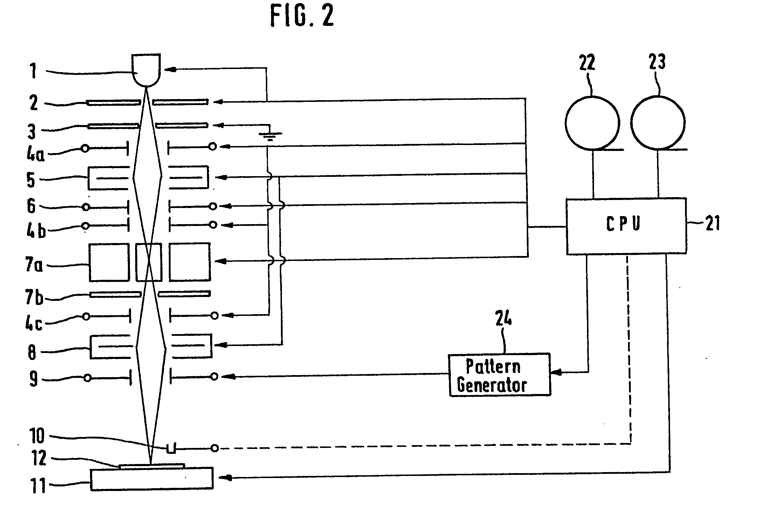

To clarify the advantages of the present invention a process, as illustrated in Fig. 1 and Fig. 2, will be described briefly. Fig. 1A is a schematic plan view of the layout of a gallium arsenide (GaAs) field effect transistor (FET). The FET has a gate electrode G, a source region S, a drain region d and channel region C. A distance from a source S to a drain d is a channel length. High performance devices typically having channel lengths of 3—6 microns (micrometers) have been proposed.

As the scale of integration of semiconductor devices increases, minimum dimension of patterns become less than a micron. In such high precision devices, it is necessary to attain the critical accuracies of each device.

Fig. 1B is a schematic plan view illustrating a focused ion beam scanning. Ions are implanted into the substrate area S by scanning the ion beam b with a pitch p, for example 0.05 to 0.1 micrometer, on the substrate expose and step operation. An ion implanted pattern has been formed by selectively scanning the focused ion beam at the beam diameters range from about 0.1—1.0 micrometer without utilizing a mask.

Fig. 2 is a schematic block diagram illustrating an apparatus for selectively implanting dopants or impurity ions into a substrate of semiconductor material without utilizing a mask. The apparatus comprises five main sections:

1. Ion source and focusing system
2. High voltage source
3. Low voltage source
4. Stage for substrate and vacuum system
5. Computer and peripherals

Fig. 2 illustrates a configuration of ion implantation system. Ions emitted from liquid metal ion (LMI) source 1 are controlled by an ion control electrode 2, beam alignments 4a, 4b and 4c, and a blanking electrode 6. They are filtered by ExB mass filter 7a which selects the ion and purity of the dopant by electric and magnetic cross field and mass separator slit 7b. Finally the doping ions are focused onto a target 12 with approximately unitary magnification. Typically, the doping ions have been focused to spot diameters ranging from 0.1 to 3.0 micrometer at about 50 keV with a constant current density of 0.5 A/cm$^2$. In addition to focusing, the lens 3, 5, and 8 also accelerate or decelerate the ion beam. The final beam energy at the target 12 on the stage 11 can be varied from 40 to 200 keV. The ion source 1 is movable to align the ion beam with the electro-optical axis of the lens.

The deflector 9 is used to electrostatically scan the ion beam across the target 12 and for calibrating astigmatism. A 100 keV ion beam can be deflected over the entire scan field of 500 micrometer retaining a 0.1 micrometer diameter of focused beam. A central processing unit (CPU) 21 controls an ion beam system of the apparatus. The CPU 21 receives an input data which includes pattern data 22 and doping data 23 stored in magnetic tape, and data coming from probe 10 for ion current measuring. Then the CPU 21 generates control signals to the element of the apparatus to control the system, such as the lens system, a faraday cup 10, the stage 11, and a pattern generator 24.

The implantation dose D (ions/cm$^2$) is given by:

$$D = \frac{I_p \cdot T}{K \cdot S \cdot q} \qquad (1)$$

where, $I_p$ is ion current (A), K is charge state of ions, S is an area of implanted region, and q is an electric charge unit ($1.602 \cdot 10^{-19}$ coulomb). Therefore, the implantation dose D (ions/cm$^2$) is controlled by ion curent $I_p$ and ion implanting time T (dwell time).

The ion beam is scanned step by step (not continuously) as shown in Fig. 1B. Area S for ion implanted region is given as

$$S = m \cdot _p \cdot n \cdot _p = m \cdot n \cdot _p{}^2 \qquad (2)$$

where, S is a target area, m and n are respectively numbers of clock pulses for scanning to X and Y directions of the target area. If clock frequency is

$f_c$, the scanning time t to scan an area S can be obtained by the following equation:

$$t = m \cdot n/f_c \qquad (3)$$

when charge state of ion beam k is one (k=1), an implantation dose $D_1$ in the area S in one scanning is given by

$$D_1 = \frac{I_p \cdot t}{K \cdot S \cdot q} = \frac{I_p}{1.602 \cdot 10^{-19}} \cdot \frac{1}{f_c \cdot p^2} \qquad (4)$$

It is clear from the equation (4), the implanted dose numbers $D_1$ is proportional with ion beam diameter and ion beam density, and inversely proportional to the clock frequency $f_c$ and squares of pitch ($p^2$).

In order to obtain the desired dose D (ions/cm$^2$), it is necessary to N times repeat of scan the target. So, the dose is given as

$$D = N \cdot D_1 \qquad (5)$$

In the equations (4) and (5), the ion current $I_p$ and the scanning number N must be controlled in order to obtain a desired dose D. But when ion current $I_p$ is varied, the focus system must be adjusted in order to attain high resolution. So, it is very difficult to vary the ion current $I_p$. On the other hand, the scanning of the ion beam is linked to the clock frequency and such clock frequency $f_c$ is fixed for prior art ion implantation apparatus. Therefore, the dose can only be varied discretely and in state of the art methods it is impossible to vary the dose D precisely.

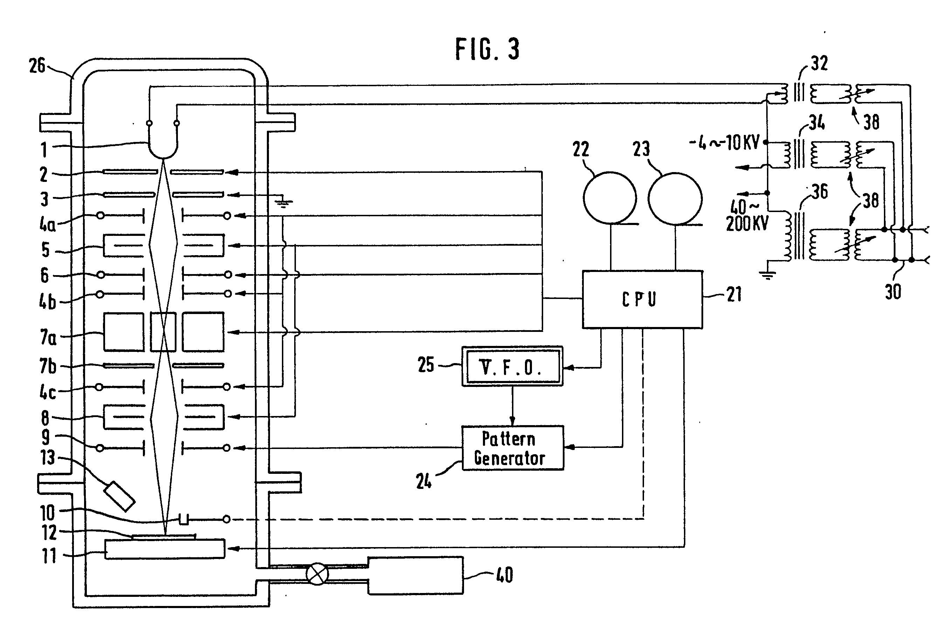

Fig. 3 is a schematic block diagram illustrating an ion implantation apparatus according to the present invention. The figure illustrates the basic elements of a focused ion beam system of the apparatus corresponding to that of Fig. 2. The difference between the apparatus of Fig. 3 and Fig. 2 is that there is further provided a variable frequency oscillator (V.F.O.) 25.

In Fig. 3, same or similar reference numerals denote the same or similar parts to Fig. 2. The function of the focused ion beam system is to produce and deliver ions in the range of energies from 40 to 200 keV to a target substrate 12.

**Claims**

1. A method for doping into a pattern on a substrate (12) by irradiating said substrate with a focused ion beam of constant current ($I_p$), said irradiation being done by scanning in a step by step movement with a clock frequency ($f_c$), characterized in that the substrate (12) is scanned N times by said focused ion beam, N being an integer greater than one, the values of N and the clock frequency ($f_c$) being chosen such that a predetermined ion density (D, $D_0$) is obtained.

2. Method according to claim 1, characterized in that said ion beam current ($I_p$) is measured by using a Faraday cup as a probe (10) and that said clock frequency ($f_c$) is supplied with a continuously variable frequency oscillator (25).

3. Method according to any one of the preceding claims, characterized in that said scanning number (N) is determined as an integer to yield said predetermined dosage ($D_0$) and minimize the implantation damage in said substrate (12) for said dosage ($D_0$).

4. Method according to any one of the preceding claims, characterized in that said desired implantation dosage ($D_0$) is continuously variable at a given ion current ($I_p$) by adjusting parameters N, $f_c$ and p according to the following relationship:

$$D = 6.24 \cdot 10^8 \cdot N \cdot I_p/(f_c \cdot p^2),$$

where p is the pitch with which said ion beam is shifted from one beam spot (b) to the next beam spot (b) and
where D results in ions/cm², 
when $I_p$ is given in pA, 
$f_c$ is given in MHz and 
p is given in micrometers.

5. Method according to claim 1, characterized in that by stepwise scanning the substrate the pitch (p) between adjacent beam spots (b) is selected such, that said beam spots (b) overlap with at least half of their spot size to acquire uniformity of doping for the scanned surface.

**Patentansprüche**

1. Verfahren zum Dotieren in einem Muster auf einem Substrat (12) durch Bestrahlen des Substrats mit einem fokussierten Ionenstrahl mit konstanter Strahlstärke ($I_p$), wobei die Bestrahlung durch Abtasten in einer schrittweisen Bewegung mit einer Taktfrequenz ($f_c$) erfolgt, dadurch gekennzeichnet, daß das Substrat (12) von dem fokussierten Ionenstrahl N mal abgetastet wird, wobei N eine ganze Zahl und größer als eins ist, wobei die Werte von N und die Taktfrequenz ($f_c$) so gewählt sind, daß eine vorbestimmte Ionendichte (D, $D_0$) erreicht wird.

2. Verfahren nach Anspruch 1, dadurch gekennzeichnet, der Ionenstrahlstrom mit einem Faraday-Becher als Sonde gemessen wird und daß die Taktfrequenz ($f_c$) von einem Oszillator (25) mit kontinuierlich veränderbarer Frequenz zugeführt wird.

3. Verfahren nach einem der vorhergehenden Ansprüche, dadurch gekennzeichnet, daß die Zahl (N) der Abtastungen als eine ganze Zahl bestimmt wird, bei der die vorbestimmte Dosierung ($D_0$) erreicht und die Implantationsschäden in dem Substrat (12) für diese Dosierung ($D_0$) minimiert werden.

4. Verfharen nach einem der vorhergehenden Ansprüche, dadurch gekennzeichnet, daß die gewünschte Implantations-Dosierung ($D_0$) bei einem gegebenen Ionenstrom ($I_p$) kontinuierlich veränderbar ist, indem die Parameter N, ($f_c$) und p gemäß der folgenden Beziehung eingestellt werden:

$$D = 6{,}24 \cdot 10^8 \cdot N \cdot I_p/(f_c \cdot p^2),$$

worin p die Schrittweite ist, mit der der Ionenstrahl von einem Strahlpunkt (b) zu dem nächsten Strahlpunkt (b) verschoben wird, und
D sich in Ionen/cm² ergibt, wenn
$I_p$ in pA, 
$f_c$ in MHz und 
p in Mikrometern 
gegeben sind.

5. Verfahren nach Anspruch 1, dadurch gekennzeichnet, daß die die Schrittweite (b) zwischen benachbarten Strahlpunkten (p) bei dem schrittweisen Abtasten des Substrats so gewählt wird, daß die Strahlpunkte (b) einander mit zumindest der Hälfte ihrer Punktgröße überlappen.

**Revendications**

1. Un procédé de dopage selon un motif dans un substrat (12) en irradiant le substrat avec un faisceau d'ions focalisé ayant un courant constant ($I_p$), cette irradiation s'effectuant par balayage avec un mouvement pas à pas conformément à une fréquence d'horloge ($f_c$), caractérisé en ce qu'on balaie le substrat (12) N fois avec le faisceau d'ions focalisé, N étant un entier supérieur à un, et la valeur de N et la fréquence d'horloge ($f_c$) étant choisies de façon à obtenir une densité d'ions prédéterminée (D, $D_0$).

2. Procédé selon la revendication 1, caractérisé en ce qu'on mesure le courant du faisceau d'ions ($I_p$) en utilisant un collecteur de Faraday à titre de sonde (10), et en ce qu'on produit la fréquence d'horloge ($f_c$) avec un oscillateur (25) dont on peut faire varier la fréquence de façon continue.

3. Procédé selon l'une quelconque des revendications précédentes, caractérisé en ce que le nombre de balayages (N) est déterminé sous la forme d'un nombre entier qui procure la dose prédéterminée ($D_0$) et qui minimise l'endommagement du substrat (12) par l'implantation pour cette dose ($D_0$).

4. Procédé selon l'une quelconque des revendications précédentes, caractérisé en ce qu'on peut faire varier de façon continue la dose d'implantation désirée ($D_0$) pour un courant ionique donné ($I_p$), en réglant les paramètres N, $f_c$ et p conformément à la relation suivante:

$$D = 6{,}24 \cdot 10^8 \cdot N \cdot I_p/(f_c \cdot p^2),$$

dans laquelle p est le pas avec lequel le faisceau d'ions est décalé d'une trace de faisceau (b) vers la trace de faisceau suivante (b) et D est obtenue en ions/cm² lorsque:
$I_p$ est donnée en pA, 
$f_c$ est donnée en MHz et 
p est donné en micromètres.

5. Procédé selon la revendication 1, caractérisé en ce que dans le balayage pas à pas du substrat, le pas (p) entre des traces de faisceau adjacentes (b) est sélectionné de façon que les traces de faisceau (b) se chevauchent sur au moins la moitié de leur taille, pour assurer l'uniformité du dopage de la surface qui est balayée.

### FIG. 1A

### FIG. 1 B

FIG. 2

FIG. 3

# FIG. 4

FIG.5

```
              ┌──────────────────────┐
              │ Acceleration voltage │
              │ supply               │
              └──────────────────────┘
                         │
              ┌──────────────────────┐
              │ Focus alignment      │
              │ calibration          │
              └──────────────────────┘
                         │
              ┌──────────────────────┐
              │ Ion current          │
              │ calibration          │
              └──────────────────────┘
                         │
              ┌──────────────────────┐
              │ Focus alignment      │
              │ calibration          │
              └──────────────────────┘
                         │
              ┌──────────────────────┐
              │ Ion current          │
              │ measuring            │
              └──────────────────────┘
                         │
              ┌──────────────────────┐
              │ Stage control        │
              └──────────────────────┘
                         │
              ┌──────────────────────┐
              │ ⊿X ⊿Y ⊿θ            │
              │ calibration          │
              └──────────────────────┘
   ┌────────────┐        │
   │Pattern data│────┐   │
   └────────────┘    │ ┌──────────────────────┐
                     └─│ Pattern data         │
                       │ calibration          │
                       └──────────────────────┘
   ┌────────────┐        │
   │Doping data │────┐   │
   └────────────┘    │ ┌──────────────────────┐
                     └─│ Clock frequency      │
                       │ scanning number select│
                       └──────────────────────┘
                         │
              ┌──────────────────────┐
              │ Ion implantation     │
              └──────────────────────┘
                         │
```

## FIG. 6